Europäisches Patentamt

European Patent Office

Office européen des brevets

(19)

(11) **EP 0 621 682 B1**

(12) **FASCICULE DE BREVET EUROPEEN**

(45) Date de publication et mention
de la délivrance du brevet:
**23.07.1997   Bulletin 1997/30**

(51) Int Cl.⁶: **H03B 19/00**, G01R 23/02

(21) Numéro de dépôt: **94400838.2**

(22) Date de dépôt: **18.04.1994**

(54) **Dispositif de division de fréquence**

Einrichtung zur Frequenzteilung

Frequency divider device

(84) Etats contractants désignés:
**BE DE GB**

(30) Priorité:  **20.04.1993  FR 9304623**

(43) Date de publication de la demande:
**26.10.1994   Bulletin 1994/43**

(73) Titulaire: **COMMISSARIAT A L'ENERGIE
ATOMIQUE
75015 Paris Cédex 15 (FR)**

(72) Inventeur: **Thomas, Thierry
F-38000 Grenoble (FR)**

(74) Mandataire: **Dubois-Chabert, Guy et al
c/o BREVATOME
25, rue de Ponthieu
75008 Paris (FR)**

(56) Documents cités:
**EP-A- 0 445 979          US-A- 4 144 489
US-A- 4 556 984**

**Description**

Domaine technique

La présente invention a pour objet un dispositif de division de fréquence, appelé plus simplement diviseur de fréquence. Elle trouve de nombreuses applications dans les domaines de l'électronique et du traitement des signaux.

Etat de la technique

De nombreux types de diviseurs de fréquence sont actuellement connus de l'homme de l'art.

Un premier type de ces diviseurs de fréquence est le dispositif de division par comptage. Un tel dispositif comporte un compteur permettant d'identifier régulièrement N périodes d'un signal de fréquence f1 en fournissant un événement à chaque cycle ; le signal résultant de cette opération est un signal de fréquence f2.

Un tel dispositif a pour inconvénient de ne permettre qu'un rapport de division f1/f2 = N de valeur entière. Ce dispositif a donc un rapport de division de très faible précision.

Un second type de diviseurs de fréquence est le dispositif de division par PLL (Phase Locked Loop, en termes anglo-saxons). Un tel diviseur est décrit dans la publication de Texas Instruments intitulée "Digital phase-locked-loop filters", p. 3.807 à 3.812. Le dispositif décrit comporte un circuit bouclé permettant de comparer la phase d'un signal interne de fréquence f1* avec la phase d'un signal incident de fréquence f1 et de modifier la fréquence f1* du signal interne pour l'ajuster sur la fréquence f1 du signal incident, de façon à ce que la différence de phase entre ces deux signaux reste constante quelles que soient les modifications de la fréquence f1. Ce dispositif comporte un oscillateur interne de fréquence fo commandé par cette différence de phase. Le signal interne de fréquence f1* est obtenu par une première division par comptage de rapport M du signal de fréquence fo. Les fréquences f1 et f1* étant équivalentes m: f1 = f1* = fo/M. Le signal de fréquence f2 issu du diviseur de fréquence par PLL est obtenu par une seconde division par comptage de rapport N, par laquelle f2 = fo/N. Le signal de fréquence f2 obtenu en sortie du dispositif de division par PLL, à partir du signal de fréquence f1, s'exprime donc sous la forme

$$f1/f2 = N/M$$

où N/M est le rapport de division de ce dispositif.

Un tel dispositif a pour inconvénient d'être délicat à réaliser, notamment du fait des conditions de stabilité de l'asservissement de phase à mettre en oeuvre. Pour une bonne réalisation de ce dispositif, la valeur M ne doit pas excéder la centaine, ce qui limite la précision du rapport de fréquence pouvant être atteinte.

Un troisième type de diviseurs de fréquence est le dispositif de division par vol de cycle. Ce dispositif met en oeuvre un procédé de vol de cycle, consistant à diviser un signal de fréquence f1 en escamotant des portions de ce signal, c'est-à-dire en supprimant certaines périodes (ou cycles) de ce signal. Le signal ainsi obtenu présente une fréquence moyenne f2, inférieure à la fréquence f1. Ces périodes supprimées provoquent des effets appelés "sauts de phase" et rendent le signal de fréquence f2 irrégulier. Pour la plupart de ces dispositifs, le nombre de cycles escamotés est N-M : ces cycles sont escamotés tous les N cycles du signal de fréquence f1 ; M représente le nombre de cycles restants correspondant au signal de fréquence f2 avec M < N. Le rapport de division de ce dispositif équivaut alors à N/M.

Un tel dispositif comporte deux compteurs en série, un premier compteur pour compter le nombre de cycles à escamoter et un second compteur pour régénérer l'opération du premier compteur tous les N cycles du signa de fréquence f1.

Ce dispositif a pour inconvénient de présenter des sauts de phase pouvant devenir importants (c'est-à-dire avoir une forte amplitude) lorsque N est grand devant M. De tels sauts de phase peuvent ne pas être tolérés par le dispositif sur lequel est appliqué le signal à fréquence f2 résultant de la division de fréquence.

D'autres dispositifs diviseurs de fréquence sont également connus. En particulier, le document EP-A-0 445 979 décrit un circuit diviseur de fréquence qui reçoit, en entrée, un premier et un second signaux numériques, ainsi qu'un premier signal d'horloge et qui fournit, en sortie, un second signal d'horloge dont la fréquence équivaut à la fréquence du premier signal d'horloge divisé par le rapport des premier et second signaux numériques. Ce circuit diviseur de fréquence comporte, notamment, un soustracteur contrôlable. Or, un tel circuit diviseur de fréquence ne permet qu'une opération arithmétique de soustraction entre un paramètre de division N et une variable itérative interne au procédé de division qui ne peut pas prendre une valeur particulière fixe.

Le document US-A-4 556 984 décrit un dispositif multiplicateur/diviseur de fréquence apte à fournir un signal de sortie proportionnel à un signal de référence reçu en entrée. Ce dispositif comporte, notamment, un multiplexeur à deux entrées permettant une sélection entre les deux variables reçues en entrées. Ce dispositif ne permet donc qu'une opération de sélection entre deux variables qui sont une combinaison arithmétique des paramètres de division N et D.

Exposé de l'invention

La présente invention a justement pour but de remédier à ces inconvénients. A cette fin, elle propose un dispositif de division de fréquence par vol de cycle, dans lequel le choix des cycles a escamoter est réalisé de façon très précise de sorte que le rapport de division puisse être d'une grande précision, en présentant des sauts de phase réduits.

De façon plus précise, l'invention concerne un dispositif de division d'un signal électrique de fréquence f1 par un nombre de rapport M/m pour fournir un signal électrique de fréquence f2, où la fréquence f2 est inférieure à la fréquence f1. Ce dispositif se caractérise par le fait, d'une part, qu'il comporte :

- des moyens de mise en forme recevant un signal de fréquence f1 et aptes à émettre un signal périodique logique à ladite fréquence f1 ;
- des moyens de mémorisation de valeurs itératives (...Ri, Ri+1, ...) comprenant une première entrée connnectée aux moyens de mise en forme pour recevoir le signal périodique émis à la fréquence f1 ;
- des moyens de détermination d'informations comportant une entrée connectée sur une sortie des moyens de mémorisation pour recevoir la valeur itérative Ri mémorisée dans lesdits moyens de mémorisation, ces moyens de détermination étant aptes, d'une part, à déterminer le signe de polarité de la valeur itérative et à convertir ce signe de polarité en une information binaire pouvant être dans un premier ou un second état, cette information étant fournie sur une première sortie et, d'autre part, à déterminer un signal de fréquence à partir de cette information relative à la valeur itérative ;
- des moyens arithmétiques qui comprennent :

    . un circuit d'opération conditionnelle apte à recevoir sur une première entrée connectée à la première sortie des moyens de détermination, l'information binaire, sur une seconde entrée la valeur m et éventuellement sur une troisième entrée la valeur M et apte à fournir sur une sortie, soit la valeur m-M, soit la valeur m en fonction de l'état de l'information binaire ; et

    . un circuit additionneur apte à recevoir sur une quatrième entrée connectée à la sortie des moyens de mémorisation, la valeur itérative et sur une cinquième entrée connectée à la sortie du circuit d'opération conditionnelle la valeur m-M ou m, et à fournir à chaque période du signal de fréquence une nouvelle valeur itérative (Ri+1) transmise au moyen de mémorisation par une sortie connectée sur une seconde entrée desdits moyens de mémorisation;

    et, d'autre part, que le rapport M/m est une valeur paramétrée, où m est une valeur paramétrée et M est une valeur particulière prédéfinie dans le circuit d'opération conditionnelle.

Avantageusement, les moyens de détermination d'informations comportent un premier circuit logique apte à déterminer le signe de polarité de la valeur itérative Ri et à convertir ce signe de polarité en une information binaire I pouvant être dans un premier ou un second état. Ils comportent un second circuit logique apte à déterminer la fréquence à laquelle l'information binaire est dans son premier état, cette fréquence correspondant à la fréquence f2.

Selon un mode de réalisation, le circuit d'opération conditionnelle comporte un circuit apte à effectuer une soustraction des valeurs m et M. Ce circuit est soit un additionneur, auquel cas il reçoit sur ses entrées les valeurs m et -M, soit un soustracteur, auquel cas il reçoit sur ses entrées les valeurs m et M, cet additionneur ou ce soustracteur étant associé à un sélecteur de bus de données.

Selon un autre mode de réalisation de l'invention, le circuit d'opération conditionnelle comporte un circuit apte à sélectionner en fonction de l'information I la modification ou non du signe de m afin de fournir en sortie du circuit d'opération conditionnelle la valeur de m avec un signe éventuellement modifié.

Le dispositif de l'invention peut comporter en outre un circuit diviseur de fréquence comprenant une entrée connectée à la sortie des moyens de détermination et assurant une division de la fréquence f2, obtenue en sortie desdits moyens de détermination, par un nombre entier K afin d'avoir un rapport de division (MxK)/m.

Ce dispositif de l'invention peut s'appliquer à la mesure d'une fréquence f4 à partir de la relation m = [(MxK)/f3)] x f4 où (MXK)/f3 est un facteur de conversion entre la fréquence mesurée f4 et une donnée numérique m.

Brève description des dessins

- La figure 1 est une représentation graphique de la valeur du rapport de division M/m lors de sauts de phase du signal de sortie de fréquence f2 ;
- la figure 2 représente de façon schématique le circuit de connexion des moyens utilisés dans le dispositif de l'invention ;
- la figure 3 représente le circuit de connexion de la figure 2 dans un mode de réalisation préféré de l'invention ;
- la figure 4 représente un synoptique du dispositif selon l'invention, dans son mode de réalisation préféré.
- la figure 5 représente un schéma de fonctionnement du dispositif selon l'invention dans une application particulière d'analyse fréquentielle.

Exposé détaillé de modes de réalisation

Le dispositif de division de fréquence selon l'invention met en oeuvre le procédé connu de vol de cycle décrit précédemment. Ce dispositif comporte, notamment, des moyens pour choisir les cycles à escamoter dans le signal d'entrée de fréquence f1, afin d'obtenir un signal de sortie de fréquence f2 approximativement régulier, c'est-à-dire un signal de sortie comportant des sauts de phase d'amplitude minimum.

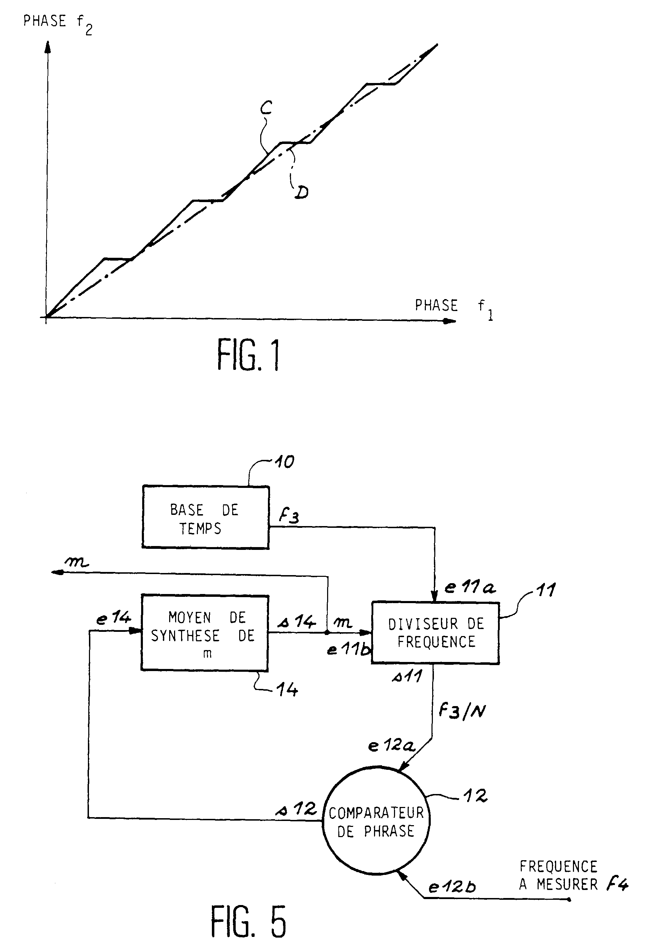

La figure 1 annexée montre une représentation graphique de la valeur du rapport de division M/m lors des sauts de phase sur le signal de sortie de fréquence f2. Sur cette représentation graphique, on a représenté en abscisse la phase du signal d'entrée de fréquence f1 et en ordonnée la phase du signal de sortie f2. La courbe c représentée sur cette figure 1, montre l'évolution de la valeur instantanée du rapport de division M/m lors de saut de phase sur le signal de sortie de fréquence f2. La droite D, représentée sur cette figure 1, montre la valeur instantanée du même rapport de division M/m dans le cas où il n'y aurait pas de saut de phase. La courbe C représentant la valeur du rapport de division M/m dans le cas du procédé de division par vol de cycle est une ligne brisée. Les sauts de phase du signal de sortie de fréquence f2 sont représentés par chaque brisure de la ligne ; plus la ligne brisée s'écarte de la droite moyenne D, et plus l'amplitude des sauts de phase est importante, la pente de cette droite moyenne D étant représentatrice du rapport de division recherché.

Ainsi, l'invention propose d'approximer, par une ligne brisée du type de la courbe C, une droite D de pente M/m, et ce, afin de permettre le choix des cycles à escamoter dans le signal d'entrée de fréquence f1. Cette approximation de la droite D par la ligne brisée C est mise en oeuvre à l'aide d'un algorithme itératif qui permet un rapport de division M/m continuellement réglable et un minimum d'amplitude des sauts de phase.

Le dispositif selon l'invention est un dispositif séquentiel dont l'état varie à chaque période (ou cycle) du signal d'entrée de fréquence f1, selon une fonction itérative et selon une donnée itérative mémorisée lors de la période précédente. Ce dispositif met en oeuvre un calcul itératif à l'aide de fonctions électroniques de logique séquentielle câblées et programmées offertes par l'industrie électronique sous forme de composants spécifiques.

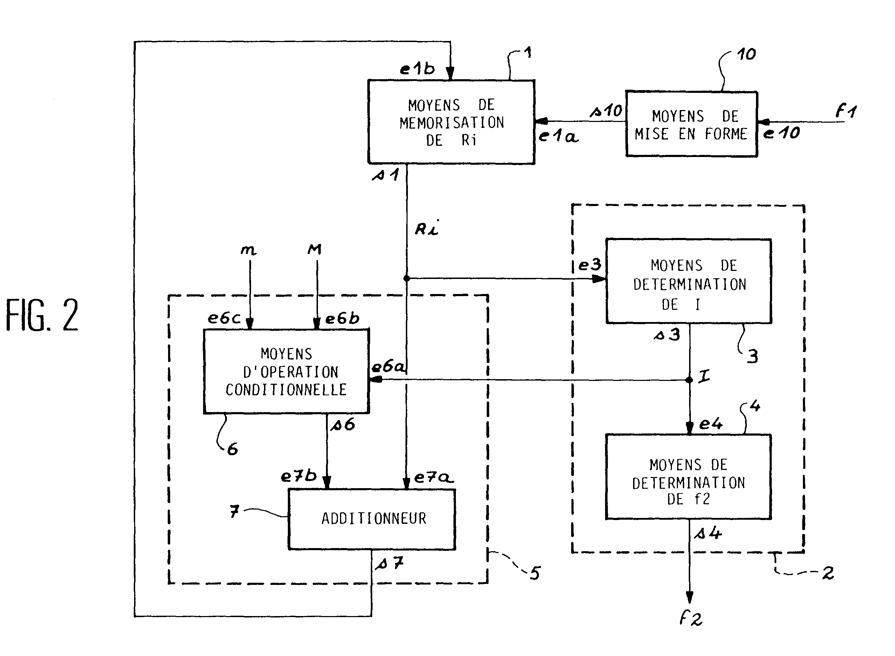

La figure 2 représente le circuit de connexion des moyens utilisés par le dispositif selon l'invention. Ce schéma montre les différents moyens constituant le dispositif de division de fréquence de l'invention et leurs liaisons les uns avec les autres.

Une fonction itérative est donc mise en oeuvre par ce dispositif. Elle a pour valeurs itératives, les valeurs ..., Ri, Ri+1,... avec $1 \leq i \leq w$. Ces valeurs itérativeS Ri sont mémorisées dans les moyens de mémorisation 1.

On considère, pour la suite de la description, que le traitement mis en oeuvre par le dispositif de l'invention s'effectue sur la valeur itérative Ri étant entendu que le traitement s'effectue successivement sur les valeurs R1 à Rw.

Ainsi, la valeur mémorisée dans les moyens de mémorisation 1 est la valeur Ri. Ces moyens de mémorisation 1 comportent une entrée e1b apte à recevoir chacune des valeurs itératives ...,Ri+1, Ri+2,... . Ces moyens comportent en outre une entrée e1a connectée à la sortie des moyens de mise en forme 10. Ces moyens de mise en forme 10 reçoivent un signal de fréquence f1 et fournissent aux moyens de mémorisation 1 un signal logique de fréquence f1. Ces moyens de mise en forme 10 peuvent être réalisés, par exemple, par un comparateur de niveaux si f1 est la fréquence d'un signal électrique.

Cette fréquence f1 cadence l'indice d'itération i des valeurs itératives Ri. La sortie s1 de ces moyens de mémorisation 1 est connectée à l'entrée e3 des moyens 3 de détermination de l'information binaire I, et à l'entrée e7a de l'additionneur 7 (nommé aussi circuit additionneur). Ces moyens 3 de détermination de l'information binaire I reçoivent donc, par leur entrée e3, la valeur itérative Ri. Ils comportent un circuit logique apte à déterminer le signe de polarité de la valeur itérative Ri, c'est-à-dire le signe + ou - qui précède la valeur Ri. Ces moyens 3 de détermination sont aptes, en outre, à convertir le signe de polarité ainsi déterminé en une information I écrite sous forme binaire. Cette information I étant binaire, elle peut prendre un premier état "0" ou un second état "1".

Cette information binaire I est introduite ensuite dans les moyens 4 de détermination de la fréquence f2 par l'entrée e4 connectée à la sortie s3 des moyens 3 de détermination du signe de Ri. Ces moyens 4 de détermination de f2 sont aptes à extraire de l'information binaire I, la valeur de la fréquence f2. De façon plus précise, les moyens 4 de détermination de la fréquence f2 recherchent la fréquence à laquelle l'information binaire I revient à un même état après un changement d'état. Selon un mode de réalisation de l'invention, ces moyens 4 de détermination de la fréquence f2 peuvent être réalisés par un circuit logique du type translateur de niveau. Ces moyens de détermination 4 de la fréquence f2 et ces moyens 3 de détermination du signe de polarité forment les moyens 2 de détermination d'informations.

L'information binaire I est alors introduite dans les moyens arithmétiques 5 par l'entrée e6a connectée sur la sortie s3 des moyens 3 de détermination. De façon plus précise, l'information binaire I est introduite par l'entrée e6a dans les moyens 6 d'opération conditionnelle. Ces moyens 6 d'opération conditionnelle comportent également une entrée e6b par laquelle est introduite la valeur M et une entrée e6c par laquelle est introduite la valeur m. Ces valeurs M et m sont des valeurs paramétrées choisies par l'utilisateur du dispositif et dont le rapport M/m correspond au rapport de division du dispositif de l'invention. Les valeurs Ri, m et M sont des valeurs numériques signées par un signe de polarité + ou - ; ces valeurs RI, m et M peuvent donc être positives ou négatives ; elles sont codées en mots binaires de n bits. Une ou plusieurs opérations arithmétiques peuvent donc être effectuées sur ces valeurs m, M et Ri en fonction de l'état de l'information binaire I. En outre, le rapport M/m est une valeur paramétrée ; elle peut donc être modifiée par l'utilisateur du dispositif. D'une façon générale, chacune des valeurs m et M sont des paramètres appliqués au dispositif par l'utilisateur dudit dispositif ou par des moyens automatiques non décrits dans cette description. Des modes de réalisation particuliers peuvent cependant être envisagés ; ils seront décrits plus en détails dans la suite de la description.

Ainsi, les moyens 6 d'opération conditionnelle effectuent en effet une première opération ou une seconde opération en fonction de l'état de l'information binaire I reçue à l'entrée e6a. Lorsque l'information I est dans son état "1", ce qui signifie que la valeur itérative Ri est positive ou nulle, alors les moyens d'opération conditionnelle effectuent, par l'intermédiaire d'un soustracteur, une soustraction entre la valeur m et la valeur M et fournissent la valeur m-M sur leur sortie s6. Au contraire, lorsque l'information binaire I est dans son état "0", ce qui signifie que la valeur itérative Ri est négative, alors les moyens 6 d'opération conditionnelle restituent la valeur m en sorties s6 des moyens 6 d'opération conditionnelle. Selon un mode de réalisation particulier du dispositif, un sélecteur (non représenté sur la figure par mesure de simplification de la figure) est connecté par sa sortie sur l'entrée e6b des moyens 6 d'opération conditionnelle et reçoit en entrées d'une part la valeur M et d'autre part la valeur 0. Il assure la sélection de l'opération à effectuer en fournissant l'une ou l'autre de ces valeurs au circuit apte à effectuer la soustraction.

Ainsi, selon l'état de l'information I, la donnée de résultat obtenue en sortie s6 des moyens 6 d'opération conditionnelle équivaut à m ou à m-M. La donnée de résultat est introduite par l'entrée e7b dans l'additionneur 7. Cet additionneur 7 reçoit en outre la valeur itérative Ri provenant des moyens de mémorisation 1 et introduite dans ledit additionneur 7 par son entrée e7a. Cet additionneur 7 effectue la somme entre la valeur itérative Ri reçue et la valeur m ou m-M. Le résultat obtenu en sortie s7 de cet additionneur 7 correspond à la valeur itérative suivante Ri+1, c'est-à-dire la valeur itérative correspondant au cycle suivant du signal de fréquence f1. Cette valeur itérative Ri+1 est introduite dans les moyens de mémorisation 1 au cycle suivant du signal logique de fréquence f1.

Selon un premier mode de réalisation particulier de l'invention, les moyens d'opération arithmétique 5 comportent de plus un inverseur permettant de modifier le signe de polarité de la valeur paramétrée M. De cette façon, une valeur -M est introduite dans les moyens 6 d'opération conditionnelle. Ces moyens 6 d'opération conditionnelle comportent alors un additionneur assurant l'addition de m et de -M lorsque l'information binaire I se présente à l'entrée e6a dans son état "1". Ce mode de réalisation permet de simplifier le circuit logique des moyens 6 d'opération conditionnelle par l'utilisation d'un additionneur au lieu d'un soustracteur comme proposé dans le mode de réalisation principal de l'invention.

Selon un second autre mode de réalisation particulier de l'invention, il est possible de choisir pour la valeur M un nombre particulier pré-défini, le rapport de division M/m restant une valeur paramétrée puisque la valeur m est une valeur paramétrée choisie par l'utilisateur. De façon plus précise, dans ce cas, la valeur M est prédéfinie par le concepteur du dispositif de façon à ce que la transcription binaire signée de la valeur -M ne présente que des "0" pour les bit de sa partie absolue et un bit à "1" pour le bit de signe. La valeur de M équivaut alors à $2^{(n-1)}$, où n est le nombre total de bits de la transcription binaire (ce nombre total de bits comprenant le bit de signe).

Selon ce mode de réalisation, les moyens d'opération conditionnelle 6 consistent en une simple combinaison logique de signes : m est choisi toujours positif, son bit de signe valant "0". Le signe de la donnée de résultat obtenue à la sortie s6 est "1" (c'est-à-dire le signe de -M) lorsque l'information binaire I reçue à l'entrée e6a est dans son état "1". Le signe de la donnée de résultat obtenue en sortie s6 est "0" lorsque l'information binaire I est reçue dans son état "0". En définitive, le signe de la donnée de résultat est toujours égal à l'information I et la partie absolue de la donnée de résultat correspond à la valeur absolue de m. Dans ce mode de réalisation, on peut donc réaliser les moyens 6 d'opération conditionnelle par de simples câblages.

Selon ce mode de réalisation, on fait abstraction de la valeur particulière M qui est implicite dans les moyens 6 d'opération conditionnelle. Dans ce mode de réalisation, il faut que l'information I corresponde à l'inverse du bit de signe Ri. Aussi, les moyens 3 de détermination de l'information I comportent un inverseur.

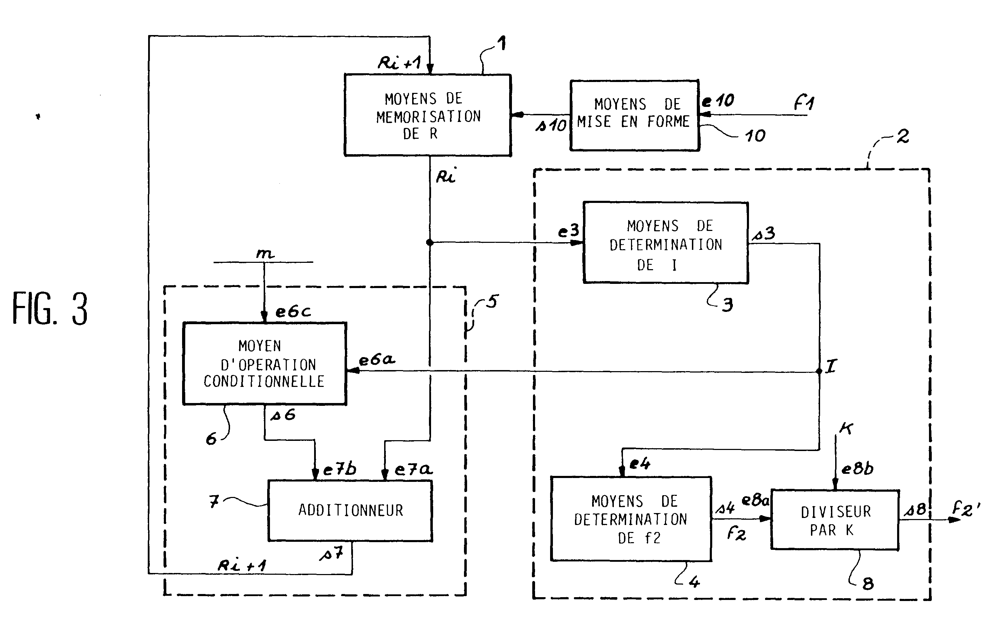

Selon un troisième mode de réalisation particulier de l'invention, le dispositif de division de fréquence selon l'invention peut comporter un diviseur de fréquence de rapport K, où K est un nombre entier. Un tel diviseur de fréquence de rapport K peut être un diviseur du type des dispositifs de division par comptage décrits comme art antérieur. Ce diviseur de fréquence est connecté sur la sortie s4 des moyens 4 de détermination de la fréquence f2. Ce mode de réalisation est représenté sur la figure 3 qui sera décrite de façon plus détaillée dans la suite de la description. Un tel diviseur de fréquence de rapport K, associé en série au dispositif de division de fréquence de rapport M/m permet une plus grande précision du rapport de division recherché. En effet, le rapport de division entre la fréquence f1 et la fréquence f2' étant (MxK)/m, il est possible d'augmenter la valeur de m tout en conservant un rapport de division identique, du fait qu'on augmente aussi K, ce qui permet d'obtenir un nombre de bits significatifs plus important. Le rapport de division entre la fréquence f1 et la fréquence f2' obtenue en sortie du diviseur de fréquence par K est alors (MxK)/m.

La figure 3 représente le dispositif de division de fréquence de l'invention selon ce troisième mode de réalisation. Sur cette figure, on voit donc les moyens 1 de mémorisation de la valeur itérative Ri et les moyens 10 de mise en forme envoyant un signal logique de fréquence f1 vers les moyens 1 de mémorisation. Cette figure 3 montre également les moyens 3 de détermination de l'information binaire I connectés par leur sortie s3 à l'entrée e6a des moyens 6 d'opération conditionnelle pour transmettre auxdits moyens 6 l'information binaire I déterminée par les moyens 3 de détermination de l'information binaire I. Les moyens 6 d'opération conditionnelle ont un rôle sensiblement identiques à celui décrit précédemment lors de la figure 2. Ils peuvent être réalisés selon l'un quelconque des modes de réalisation décrits en référence à la figure 2 et, en particulier, selon le mode de réalisation dans lequel m est paramètré et M est prédéfini (voir figure 3). Ces moyens 6 d'opération conditionnelle ne comportent ainsi que deux entrées l'entrée e6a provenant des moyens 3 de détermination de l'information I et recevant l'information binaire I et l'entrée e6c introduisant la valeur m ; la valeur M est implicite et vaut $2^{(n-1)}$. Tout comme sur la figure 2, la sortie s6 des moyens 6 d'opération conditionnelle est connectée à l'entrée e7b de l'additionneur 7.

Sur cette figure 3, on a représenté également le troisième mode de réalisation particulier décrit, à savoir le mode de réalisation dans lequel le dispositif selon l'invention comprend un diviseur de fréquence par K, où K est un nombre entier. Ainsi, la sortie s3 des moyens 3 de détermination de l'information est connectée sur l'entrée e4 des moyens 4 de détermination de la fréquence f2. Ce diviseur de fréquence par K est référencé 8 et reçoit sur une entrée e8a la fréquence f2 et sur une entrée e8b la valeur paramétrée K ; il fournit sur sa sortie s8 la fréquence f2'. Le rapport de division entre la fréquence f1 du signal d'entrée et la fréquence f2' du signal de sortie selon le mode de réalisation représenté par cette figure 3 est $(2^{(n-1)} \times K)/m$.

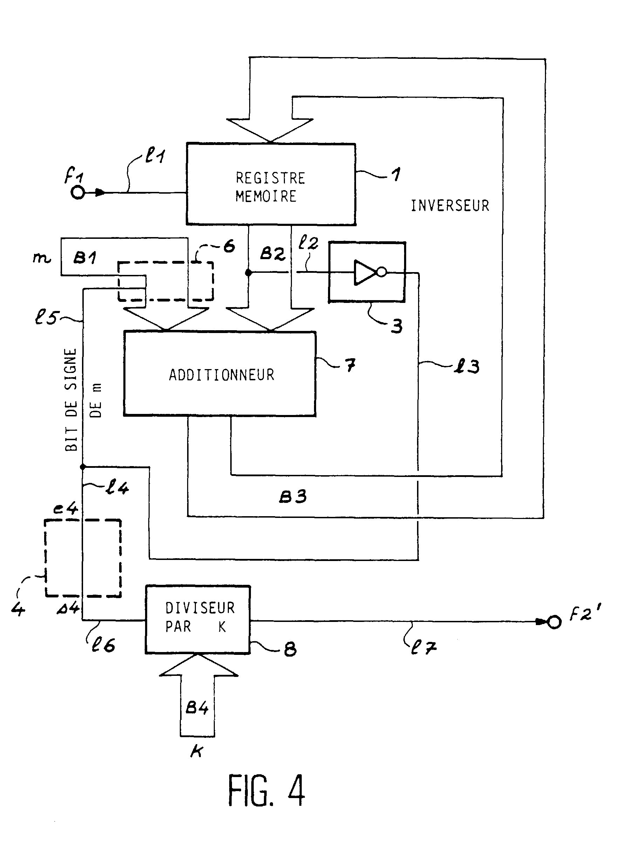

La figure 4 représente un synoptique du mode de réalisation montré sur la figure 3. Cette figure 4 montre le registre de mémoire 1, à savoir les moyens de mémorisation de la valeur itérative Ri, l'additionneur 7, le diviseur par K, 8. Sur cette figure 4 sont représentés, en traits mixtes, les moyens 4 de détermination de la fréquence f2 et les moyens 6 d'opération conditionnelle, ces moyens étant représentée en traits mixtes car ils sont réalisés par de simples connexions, notamment l'information binaire I est connectée directement en lieu et place du bit de signe de m ; l'entrée e4 et la sortie S4 des moyens 4 sont confondues. Entre les différents moyens schématisés sur cette figure 4, sont représentés également des bus de données introduisant, dans le dispositif de l'invention, les différentes données nécessaires à sa mise en oeuvre. Le bus de données B1 introduit la valeur m dans l'additionneur 7 avec, comme bit de signe, la valeur de I correspondant à l'inverse du signe de Ri ; le bus de données B2 introduit la valeur itérative Ri dans l'additionneur 7 ; le bus de données B3 introduit la nouvelle valeur itérative Ri+1 déterminée par l'additionneur 7 dans le registre de mémoire 1. Le fil de connexion 11 applique le signal de fréquence f1 au registre de mémoire 1 ; le fil de connexion 12 assure la liaison électrique entre la sortie du registre de mémoire 1 et l'entrée de l'inverseur 3. Les liaisons de connexion 13, 14 et 15 relient la sortie de l'inverseur 3 aux moyens 4 de détermination de la fréquence f2 d'une part, et aux moyens 6 d'opération conditionnelle d'autre part. Plus précisément, la liaison 15 remplace la liaison relative au bit de signe de m au sein du bus de données B1. Le bus B4 permet d'introduire la valeur paramétrée K dans le diviseur 8. Le fil de connexion 16 assure la liaison électrique entre les moyens 4 de détermination de la fréquence f2 et le diviseur par K, 8 ; et enfin, le fil de connexion 17 assure la sortie du signal de sortie de fréquence f2' fourni par le diviseur par K, 8.

Le dispositif de division de fréquence selon l'invention peut s'appliquer à de nombreuses sortes de dispositifs d'analyse fréquentielle.

Selon un premier mode d'application particulier, le diviseur de fréquence selon l'invention peut être utilisé pour effectuer une analyse fréquentielle sur des signaux ayant des fréquences de gammes différentes, associé à un même dispositif d'analyse, par exemple un fréquencemètre, ne possédant qu'une plage de travail réduite en fréquence, en divisant préalablement à l'analyse des fréquences, les fréquences trop élevées pour le dispositif d'analyse.

Selon un second mode d'application particulier, le diviseur de fréquence selon l'invention peut permettre de vérifier ou de mesurer la proportionnalité entre des signaux de fréquences f3 et f4, c'est-à-dire de vérifier ou d'obtenir l'équivalence f4 = f3/N, où N est le rapport de division équivalent à (MxK)/n tel qu'explicité précédemment dans la description où M peut prendre comme valeur $2^{(n-1)}$. Dans la pratique, l'équivalence f4=f3/N peut être traduite par le résultat d'un comparateur de phase connecté aux signaux de fréquences f4 et f3/N, le rapport de division N est ajusté par l'utilisateur ou par un processus autonome par action sur le paramètre m appliqué au diviseur de fréquence selon l'invention.

Selon un troisième mode d'application particulier, le diviseur de fréquence selon l'invention peut permettre la réalisation d'un fréquencemètre dont la mesure résultante est une donnée numérique. Un tel dispositif de mesure de fréquence effectue, selon le second mode d'application explicité précédemment, une mesure de proportionnalité entre un signal de référence de fréquence f3 et un signal incident, objet de la mesure de fréquence, de fréquence f4. Le rapport de division N = (MxK)/m est ajusté de manière autonome au sein du dispositif de mesure de fréquence par action sur le paramètre m appliqué au diviseur de fréquence agissant sur la fréquence de référence f3. Ceci nécessite un comparateur de phase agissant sur les signaux de fréquences f4 et f3/N et des moyens de synthèse de paramètre m. Dans la pratique, les moyens de synthèse de paramètre m comportent, par exemple, un compteur-décompteur et des circuits de logique combinatoire aptes à piloter ledit compteur-décompteur selon le résultat issu de comparateur de phase de façon à obtenir en sortie du comparateur l'équivalence f4 = f3/N, où N est le rapport de division équivalent à (MxK)/m tel qu'explicité précédemment dans la description, et où M peut prendre comme valeur $2^{(n-1)}$. De cette équivalence se déduit la relation de mesure de la fréquence f4 = m = [(MxK)/f3] x f4, où la quantité (MxK)/f3 représente le facteur de conversion de fréquencemètre entre la fréquence mesurée et la donnée numérique m résultat de la mesure.

Un tel dispositif est représenté sur la figure 5 annexée. Sur cette figure 5, la référence 10 représente la base de temps envoyant la fréquence f3 sur l'entrée e11a du diviseur de fréquence selon l'invention, référencé 11. La sortie s11 du diviseur de fréquence 11 fournit une fréquence intermédiaire f3/N qui est introduite dans un comparateur de phase 12 par son entrée e12a. Outre la fréquence intermédiaire f3/N introduite dans le comparateur de phase 12, une fréquence f4 est fournie à ce comparateur 12 par son entrée e12b. Le résultat obtenu à la sortie s12 de ce comparateur 12 est introduit dans les moyens 14 de synthèse de m par une entrée e14. La valeur de m obtenue en sortie s14 est alors introduite dans le diviseur de fréquence 11 par son entrée e11b, ce qui permet la mise à jour du rapport de division (MxK)/m. La valeur m est fournie en sortie de dispositif et correspond à la fréquence f4 à un facteur de conversion près.

De façon plus particulière, le dispositif selon l'invention peut s'appliquer à l'analyse de fréquence d'un signal de sortie d'un magnétomètre à résonance nucléaire ; en choisissant les paramètres M et K et la fréquence de référence f3 afin d'obtenir le facteur de conversion adéquat, la valeur paramétrique m est exprimée en nanotesla. En effet, dans le domaine de la mesure de champs magnétiques, les magnétomètres scalaires à résonance mesurent l'intensité du champ magnétique dans lequel ils sont plongés en fournissant un signal périodique. Le facteur de conversion entre le champ magnétique et la fréquence issue d'un magnétomètre à résonance nucléaire est 23,4874 nanotesla par hertz en se limitant à la quatrième décimale.

## Revendications

1. Dispositif de division d'un signal électrique de fréquence f1 par un nombre de rapport M/m pour fournir un signal électrique de fréquence f2, où la fréquence f2 est inférieure à la fréquence f1, caractérisé en ce qu'il comporte :

   - des moyens (10) de mise en forme recevant un signal de fréquence f1 et aptes à émettre un signal périodique logique à ladite fréquence f1 ;
   - des moyens (1) de mémorisation de valeurs itératives (...Ri, Ri+1, ...) comprenant une première entrée (e1a) connectée aux moyens de mise en forme pour recevoir le signal périodique logique émis à la fréquence f1 ;
   - des moyens (2) de détermination d'informations comportant une entrée (e3) connectée sur une sortie (s1) des moyens de mémorisation pour recevoir la valeur itérative Ri mémorisée dans lesdits moyens de mémorisation, ces moyens de détermination étant aptes, d'une part, à déterminer le signe de polarité de la valeur itérative et à convertir ce signe de polarité en une information (I) binaire pouvant être dans un premier ou un second état, cette information étant fournie sur une première sortie (s3) et, d'autre part, à déterminer un signal de fréquence (f2) à partir de cette information relative à la valeur itérative ;

   - des moyens arithmétiques (5) qui comprennent :

     . un circuit (6) d'opération conditionnelle apte à recevoir sur une première entrée (e6a) connectée à la première sortie des moyens de détermination, l'information binaire, sur une seconde entrée la valeur m et éventuellement sur une troisième entrée la valeur M et apte à fournir sur une sortie, soit la valeur m-M, soit la valeur m en fonction de l'état de l'information binaire ; et

     . un circuit additionneur apte à recevoir sur une quatrième entrée connectée à la sortie des moyens de mémorisation, la valeur itérative et sur une cinquième entrée (e7b) connectée à la sortie du circuit d'opération conditionnelle, la valeur m-M ou m, et à fournir à chaque période du signal de fréquence f1 une nouvelle valeur itérative (Ri+1) transmise aux moyens de mémorisation par une sortie (s7) connectée sur une seconde entrée (e1b) desdits moyens de mémorisation;

   et en ce que le rapport M/m est une valeur paramétrée, où m est une valeur paramétrée et M est une valeur particulière prédéfinie dans le circuit d'opération conditionnelle.

2. Dispositif selon la revendication 1, caractérisé en ce que les moyens de détermination d'information comportent un premier circuit logique (3) apte à déterminer le signe de polarité de la valeur itérative et à convertir ce signe de polarité en une information (I) binaire.

3. Dispositif selon la revendication 2, caractérisé en ce que les moyens de détermination comportent un second circuit logique (4) apte à déterminer la fréquence à laquelle l'information binaire est dans son premier état, cette fréquence correspondant à la fréquence (f2).

4. Dispositif selon l'une quelconque des revendications 1 à 3, caractérisé en ce que le circuit d'opération conditionnelle comporte un circuit apte à effectuer une soustraction des valeurs m et M.

**5.** Dispositif selon l'une quelconque des revendications 1 à 4, caractérisé en ce que le circuit d'opération conditionnelle comporte un circuit apte à sélectionner, en fonction de l'information binaire (I), la modification ou non du signe de m afin de fournir en sortie du circuit d'opération conditionnelle la valeur de m avec un signe éventuellement modifié.

**6.** Dispositif selon l'une quelconque des revendications 1 à 5, caractérisé en ce qu'il comporte un circuit (8) diviseur de fréquence comprenant une entrée connectée à la sortie des moyens de détermination et assurant une division de la fréquence f2, obtenue en sortie desdits moyens de détermination, par un nombre entier K afin d'avoir un rapport de division (MxK)/m.

**7.** Dispositif de mesure d'une fréquence f4 à partir de la relation m = [(MxK)/f3)] x f4 où (MxK)/f3 est un facteur de conversion entre la fréquence mesurée f4 et une donnée numérique m, caractérisé en ce qu'il consiste en un dispositif selon l'une quelconque des revendications précédentes.

**Patentansprüche**

**1.** Einrichtung zur Teilung eines elektrischen Signals der Frequenz f1 durch eine Verhältniszahl M/m, um ein elektrisches Signal der Frequenz f2 zu liefern, wobei die Frequenz f2 kleiner ist als die Frequenz f1,
dadurch gekennzeichnet, daß sie umfaßt:

- Formungseinrichtungen (10), die ein Signal der Frequenz f1 empfangen und fähig sind, ein logisches periodisches Signal mit besagter Frequenz f1 zu senden;
- Speichereinrichtungen (1) der iterativen Werte (...Ri, Ri+1, ...), einen ersten Eingang (e1a) umfassend, verbunden mit den Formungseinrichtungen, um das mit der Frequenz f1 gesendete logische periodische Signal zu empfangen;
- Informationsbestimmungseinrichtungen (2), einen Eingang (e3) umfassend, angeschlossen an einem Ausgang (s1) der Speichereinrichtungen, um den iterativen Wert Ri, gespeichert in den genannten Speichereinrichtungen, zu empfangen, wobei diese Bestimmungseinrichtungen fähig sind, einerseits das Vorzeichen des iterativen Werts zu bestimmen und dieses Vorzeichen in eine binäre Information (I) zu invertieren, die in einem ersten und einem zweiten Zustand sein kann, und diese Information an einem ersten Ausgang (s3) geliefert wird, und andererseits ein Signal der Frequenz (f2) zu bestimmen aufgrund dieser den iterativen Wert betreffenden Information;

- arithmetische Einrichtungen (5), umfassend:

  . eine bedingte Operationsschaltung (6), fähig auf einem ersten Eingang (e6a), verbunden mit dem ersten Ausgang der Bestimmungseinrichtungen, die binäre Information zu empfangen und auf einem zweiten Eingang den Wert m sowie eventuell auf einem dritten Eingang den Wert M, und fähig, auf einem Ausgang entweder den Wert m-M oder den Wert m zu empfangen in Abhängigkeit vom Zustand der binären Information; und

  . eine Addierschaltung, fähig auf einem vierten Eingang, verbunden mit dem Ausgang der Speichereinrichtungen, den iterativen Wert und auf einem fünften Eingang (e7b), verbunden mit dem Ausgang der bedingten Operationsschaltung, den Wert m-M oder m zu empfangen und mit jeder Periode des Signals der Frequenz f1 einen neuen iterativen Wert (Ri+1) zu liefern, der an die Speichereinrichtungen übertragen wird über einen Ausgang (s7), der mit einem zweiten Eingang (e1b) der besagten Speichereinrichtungen verbunden ist;

und dadurch, daß das Verhältnis M/m ein parametrierter Wert ist, wob m ein parametrierter Wert ist und M ein besonderer, in der bedingten Operationsschaltung festgelegter Wert ist.

**2.** Vorrichtung nach Anspruch 1, dadurch gekennzeichnet, daß die Informationsbestimmungseinrichtungen eine erste logische Schaltung (3) umfassen, fähig das Vorzeichen des iterativen Werts zu bestimmen und dieses Vorzeichen in eine binäre Information (I) zu konvertieren.

**3.** Vorrichtung nach Anspruch 2, dadurch gekennzeichnet, daß die Bestimmungseinrichtungen eine zweite logische Schaltung (4) umfassen, fähig die Frequenz zu bestimmen, mit der die binäre Information in ihrem ersten Zustand ist, wobei diese Frequenz der Frequenz (f2) entspricht.

**4.** Vorrichtung nach einem der vorangehenden Ansprüche, dadurch gekennzeichnet, daß die bedingte Operationsschaltung eine Schaltung umfaßt, die eine Subtraktion der Werte m und M ausführen kann.

**5.** Vorrichtung nach einem der Ansprüche 1 bis 4, dadurch gekennzeichnet, daß die bedingte Operationsschaltung einen Schaltkreis umfaßt, der in Abhängigkeit von der binären Information (I) wählen kann, das Vorzeichens von m zu ändern oder nicht zu ändern, um als Ausgang der bedingten Operationsschaltung den Wert von m mit einem eventuell geänderten Vorzeichen zu liefern.

6. Vorrichtung nach einem der Ansprüche 1 bis 5, dadurch gekennzeichnet, daß sie eine Frequenzteilungsschaltung (8) umfaßt, die einen Eingang hat, der mit dem Ausgang der Bestimmungseinrichtungen verbunden ist und eine Teilung der als Ausgang der Bestimmungseinrichtungen erhaltenen Frequenz f2 durch eine Ganzzahl K sicherstellt, um ein Teilungsverhältnis (MxK)/m zu bekommen.

7. Vorrichtung zum Messen einer Frequenz f4 aufgrund der Relation m = [(MxK)/f3] x f4 oder (MxK)/f3, wobei (MxK)/f3 ein Konversionsfaktor zwischen der gemessenen Frequenz f4 und einer gegebenen Digitalgröße m ist, dadurch gekennzeichnet, daß sie gebildet wird durch eine Vorrichtung nach einem der vorangehenden Ansprüche.

**Claims**

1. Device for dividing an electric signal of frequency f1 by a number of ratio M/m in order to supply an electric signal of frequency f2, in which the frequency f2 is below the frequency f1, characterized in that it comprises:

   - shaping means (10) receiving a signal of frequency f1 and able to emit a logic periodic signal at said frequency f1,
   - means (1) for storing iterative values (... Ri, Ri+1, ...) having a first input (e1a) connected to the shaping means in order to receive the periodic signal emitted at the frequency f1,
   - information determination means (2) having an input (e3) connected to an output (s1) of the storage means for receiving the iterative value Ri stored in said storage means, said determination means being able, on the one hand, to determine the polarity sign of the iterative value and convert said polarity sign into a binary information (I) which can be in a first or second state, said information being supplied to a first output (s3) and, on the other hand, determine a frequency signal (f2) on the basis of this information relative to the iterative value,
   - arithmetic means (5) comprising:

     a conditional operation circuit (6) able to receive on a first input (e6a) connected to the first output of the determination means, the said binary information, on a second input the value m and optionally on a third input the value M and able to supply on an output, either the value m-M, or the value m as a function of the binary information state, and

an adder circuit able to receive on a fourth input (e7b) connected to the output of the storage means, the iterative value and on a fifth input connected to the output of the conditional operation circuit the value m-M or m, and supply for each period of the frequency signal a new iterative value (Ri+1) transmitted to the storage means by an output (s7) connected to a second input (e1b) of said storage means; and in that the ration M/m is a parametrized value, in which m is a parametrized value and M is a particular value previously defined in the conditional operation circuit.

2. Device according to claim 1, characterized in that the information determination means incorporate a first logic circuit (3) able to determine the polarity sign of the iterative value and convert said polarity sign into a binary information (I).

3. Device according to claim 2, characterized in that the determination means incorporate a second logic circuit (4) able to determine the frequency at which the binary information is in its first state, said frequency corresponding to the frequency (f2).

4. Device according to any one of the claims 1 to 3, characterized in that the conditional operation circuit comprises a circuit able to perform a subtraction of the values m and M.

5. Device according to any one of the claims 1 to 4, characterized in that the conditional operation circuit comprises a circuit able to select, as a function of the binary information (I), the modification or non-modification of the signal of m in order to supply at the output of the conditional operation circuit, the value of m with an optionally modified sign.

6. Device according to any one of the claims 1 to 5, characterized in that it comprises a frequency dividing circuit (8) having an input connected to the output of the determination means and ensuring a division of the frequency f2, obtained at the output of said determination means, by an integer K in order to have a division ratio (MxK)/m.

7. Device for measuring a frequency f4 from the relation m = [(MXK)/f3] x f4 in which (MxK)/f3 is a conversion factor between the measured frequency f4 and a digital data item m, characterized in that it is constituted by a device according to any one of the preceding claims.

PHASE $f_2$

C

D

PHASE $f_1$

## FIG. 1

10 ⌒

BASE  DE
TEMPS

$f_3$

$m$

$e\ 14$

MOYEN   DE
SYNTHESE   DE
$m$

$s\ 14$

$m$

$e\ 11a$      11 ⌒

DIVISEUR DE
FREQUENCE

$e\ 11b$

$s\ 11$

14 ⌒

$f_3/N$

$e\ 12a$

$s\ 12$

COMPARATEUR
DE PHRASE

12

$e\ 12b$

FREQUENCE
A MESURER $f_4$

## FIG. 5

FIG. 2

EP 0 621 682 B1

FIG. 3

FIG. 4